Europäisches Patentamt

European Patent Office

Office européen des brevets

(19)

(11) **EP 0 853 378 A2**

(12) **EUROPEAN PATENT APPLICATION**

(43) Date of publication:
**15.07.1998 Bulletin 1998/29**

(51) Int. Cl.$^6$: **H03F 1/30**

(21) Application number: **98100173.8**

(22) Date of filing: **07.01.1998**

(84) Designated Contracting States:
**AT BE CH DE DK ES FI FR GB GR IE IT LI LU MC NL PT SE**
Designated Extension States:
**AL LT LV MK RO SI**

(30) Priority: **10.01.1997 JP 3109/97**

(71) Applicant: **NEC CORPORATION Tokyo (JP)**

(72) Inventor: **Yamaguchi, Yu Minato-ku, Tokyo (JP)**

(74) Representative: **Betten & Resch Reichenbachstrasse 19 80469 München (DE)**

(54) **Bias circuit for FET amplifier**

(57)     The present invention has an object to prevent a drain current of an FET from substantially changing due to temperature variation when a drain voltage of the field effect transistor is set in the vicinity of a positive power source voltage. In a D.C. bias circuit of a FET (Q1) having a source grounded, in order to maintain a drain-source voltage and a drain current of the FET automatically constant regardless of variation of D.C. parameters, a first PNP transistor (Q2) is provided between the drain and the gate of the FET (Q1). A bias circuit including a second PNP transistor (Q3) is connected to a base of the first PNP transistor (Q2).

The transistors (Q2) and (Q3) have substantially the same characteristics so that a variation of a drain voltage and a drain current due to temperature variation of the emitter-base voltage of the transistor (Q2) can be compensated for and the substantial variation of the drain current is prevented.

FIG.1

**Description**

BACKGROUND OF THE INVENTION

The present invention relates to a bias circuit for a field effect transistor (FET) and, particularly, to a bias circuit for an FET micro wave amplifier for maintaining a drain current of an FET thereof at constant value.

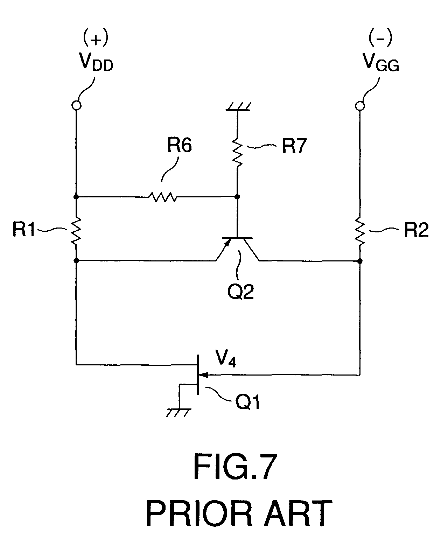

An example of the conventional bias circuit for an FET amplifier of this kind is disclosed in, for example, Japanese Patent Application Laid-open No. H3-11682. The disclosed conventional bias circuit is used to automatically hold a drain-source voltage and hence a drain current of an FET at constant values even when D.C. parameters of the FET are varied for some reason. Fig. 7 is a circuit diagram of the disclosed conventional bias circuit for the FET amplifier. In the D.C. bias circuit for a grounded source type FET Q1 shown in Fig. 7, a gate electrode of the FET Q1 is connected through a resistor R2 to a negative power source VGG and a drain electrode thereof is connected through a resistor R1 to a positive power source VDD. A collector electrode of a PNP bipolar transistor Q2 is connected to a junction between the gate electrode of the FET Q1 and the resistor R2 and an emitter electrode of the PNP bipolar transistor Q2 is connected to a junction between the drain electrode of the FET Q1 and the resistor R1. Further, a base electrode of the PNP bipolar transistor is connected to the positive power source VDD through a resistor R6 and grounded through a resistor R7. This bias circuit is featured in that it operates to compensate for changes of a drain current and hence a drain-source voltage of the FET Q1, which are caused by changes of the D.C. parameters of the FET.

Further, according to the circuit construction mentioned above, it is possible to automatically hold the drain-source voltage and the drain current of the FET at respective constant values.

The above mentioned operation of the bias circuit shown in Fig. 7 will be described in more detail. The bias circuit is constructed with the FET Q1, the PNP bipolar transistor Q2 and the resistors R1, R2, R6 and R7. A value of the resistor R1 is selected such that, when a predetermined drain current flows the FET, the drain-source voltage becomes a predetermined value and the resistors R6 and R7 determine a reference voltage to be applied to the base electrode of the PNP bipolar transistor Q2. The reference voltage is determined such that it is lower than the drain-source voltage by a value corresponding to a base-emitter voltage. A value of the resistor R2 is selected such that, when a collector current of the PNP bipolar transistor Q2 flows therethrough, a voltage corresponding to a change of the collector current is applied to the gate electrode of the FET Q1.

Assuming that the D.C. parameters of the FET Q1 are changed for some reason and the drain current is reduced correspondingly thereto, a voltage drop across the resistor R1 is reduced by the reduction of the drain current and hence the drain-source voltage of the FET Q1 is increased. Then, the base-emitter voltage of the PNP bipolar transistor is increased, the base current is increased and thus the collector current is increased. Since the increase of the collector current makes the voltage drop across the resistor R2 larger, the voltage applied to the gate of the FET Q1, that is, the gate-source voltage thereof, is reduced. Therefore, the drain current is increased and thus the drain current and hence the drain-source voltage is maintained constant.

In the conventional technique mentioned above, the emitter-base voltage of the PNP transistor Q2 varies with variation of temperature and, therefore, the drain voltage of the FET Q1 is changed with the temperature variation by the amount of variation of the emitter-base voltage. The drain current depends upon a difference between the drain voltage and the positive power source voltage VDD applied across the resistor R1. Therefore, when the drain voltage is set in the vicinity of the positive power source voltage VDD, the voltage applied across the resistor R1 becomes small and an effect of the drain voltage variation on a drain current variation becomes large. As a result, the drain current changes drastically. Therefore, when the drain voltage of the FET Q1 is set in the vicinity of the positive power source voltage VDD, such as in a case where the positive power source voltage VDD is made lower, it is impossible to hold the drain current constant.

SUMMARY OF THE INVENTION

An object of the present invention is to provide a bias circuit of an FET amplifier, with which a substantial change of the drain current of an FET of the amplifier due to temperature variation is prevented from occurring even if the drain voltage of the FET is set in the vicinity of a voltage of a positive power source voltage of the amplifier.

According to the present invention, the bias circuit of a grounded source type FET amplifier is featured by that a first transistor is connected between a drain electrode and a gate electrode of the FET and a second transistor is connected to a drain resistor of the FET and the first transistor.

Further, a base of the second transistor is directly connected to an emitter thereof.

The bias circuit according to the present invention is further featured by that an emitter-base voltage characteristics of the first transistor is substantially the same as an emitter-base voltage characteristics of the second transistor.

Further, the first and second transistors are PNP transistors when the FET is of N channel junction type or NPN transistors when the FET is of P channel junction type.

In addition, the bias circuit of the present invention is featured by comprising means for regulating a base voltage of the first transistor.

In the bias circuit according to the present invention, a PNP transistor Q3 which has a base and a collector directly connected to the base and which is of the same type as that of a PNP transistor Q2 is additionally provided in a biasing circuit portion provided in the bias circuit for providing a base potential of the PNP transistor Q2. When an emitter-base voltage of the PNP transistor Q2 is varied with temperature variation, an emitter-base voltage of the PNP transistor Q3 is varied similarly to the emitter-base voltage variation of the PNP transistor Q2 so that the base potential of the PNP transistor Q2 is varied. Therefore, a drain voltage of the FET Q1 becomes substantially constant and a drain current thereof is maintained at constant even when the drain voltage is set in the vicinity of a positive power source voltage VDD of the FET amplifier.

BRIEF DESCRIPTION OF THE DRAWINGS

Fig. 1 is a circuit diagram of a bias circuit for an FET amplifier, according to a first embodiment of the present invention;
Fig. 2 is a graph showing voltage-temperature characteristics of various portions of the bias circuit shown in Fig. 1;
Fig. 3 is a graph showing a drain current-temperature characteristics of an FET of the bias circuit shown in Fig. 1;
Fig. 4 is a graph showing a relation between a variation rate of drain current of the FET with temperature and drain voltage of the FET according to the present invention in comparison with that of the prior art;
Fig. 5 is a circuit diagram of a bias circuit for an FET, according to a second embodiment of the present invention;
Fig. 6 is a circuit diagram of a bias circuit for an FET, according to a third embodiment of the present invention; and
Fig. 7 is a circuit diagram of a conventional bias circuit for an FET amplifier.

DETAILED DESCRIPTION OF THE PREFERRED EMBODIMENTS

Preferred embodiments of the present invention will be described with reference to the drawings.

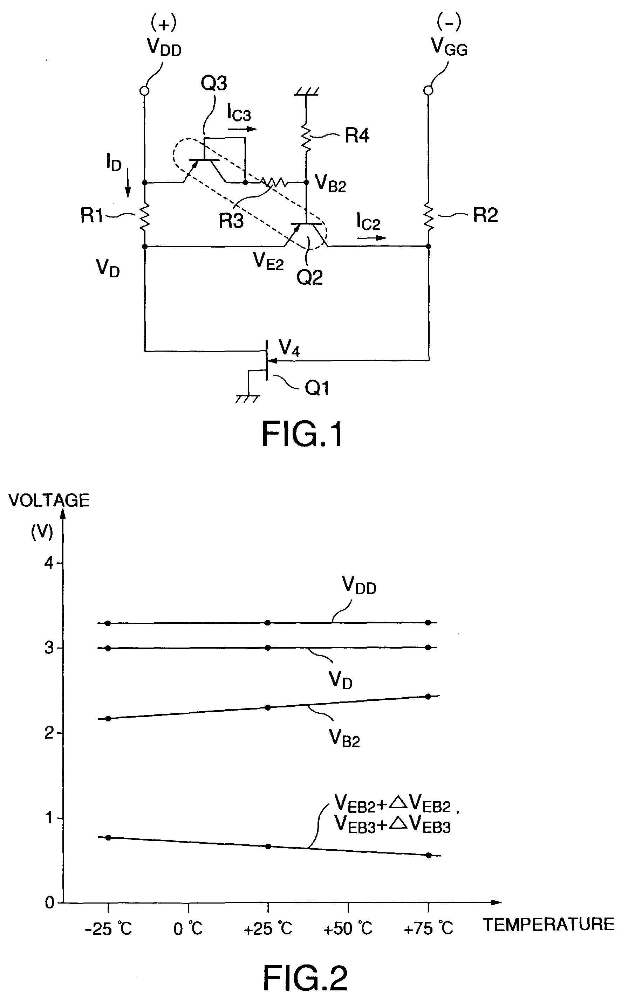

Fig. 1 is a circuit diagram of a bias circuit of an FET amplifier, according to a first embodiment of the present invention. In Fig. 1, a D.C. bias circuit of a grounded source type FET Q1 includes a PNP transistor Q2 having an emitter connected to a drain of the FET Q1 and through a resistor R1 to a positive power source VDD, a PNP transistor Q2 having a collector connected to a gate of the FET Q1 and through a resistor R2 to a negative power source VGG and a PNP transistor Q3 having an emitter connected to the positive power source VDD, a base and a collector connected directly to the base, through a resistor R3 to the base of the PNP transistor Q2 and through a resistor R4 to ground.

Now, an operation of the bias circuit shown in Fig. 1 will be described in detail with reference to Fig. 2.

In Fig. 2, VE2 depicts an emitter potential, VB2 a base potential VB2 of the PNP transistor Q2, VEB2 an emitter-base voltage, $\Delta$VEB2 a temperature caused variation of the emitter-base voltage, VEB3 an emitter-base voltage of the PNP transistor Q3, $\Delta$VEB3 a temperature caused variation of the emitter-base voltage of the transistor Q3 and VDD a voltage value of the positive power source VDD. In order to simplify an arithmetic operation, the base currents of the PNP transistors Q2 and Q3 are assumed as negligibly small.

The value of the resistor R1 is determined such that, when a predetermined drain current ID flows, the drain voltage VD of the FET Q1 becomes a predetermined value according to the following equation (1):

$$R1 = \frac{VDD - VD}{ID} \tag{1}$$

In a case where the drain voltage VD is set in the vicinity of the voltage VDD of the positive power source, the value of the resistor R1 is set in a range from several $\Omega$ to several hundreds $\Omega$.

A collector current IC2 of the PNP transistor Q2 flows through the resistor R2 and a voltage corresponding to a variation of the collector current IC2 is applied to a gate of the FET Q1 according to the following equation (2):

$$R2 = \frac{VGG - V4}{IC2} \tag{2}$$

Since the collector current IC2 should be set to a value sufficiently small with respect to the drain current ID of the FET Q1, the value of the resistor R2 is selected from a range from several k$\Omega$ to several hundreds k$\Omega$. The resistors R3 and R4 determine the base potential VB2 of the PNP transistor Q2 and have values with which the base potential VB2 is lower than the drain voltage VD of the FET Q1 by the emitter-base voltage thereof. In this case, the collector current IC3 of the PNP transistor Q3 is set to a value substantially equal to the collector current IC2 of the PNP transistor Q2. The resistor R3 may have a value in a range from several hundreds $\Omega$ to several k$\Omega$ and the resistor R4 may have a value in a range from several k$\Omega$ to several hundreds k$\Omega$. The base potential VB2 of the PNP transistor Q2 is obtained by dividing a voltage corresponding to a difference between the voltage VDD of the positive power source and the emitter-base voltage (VEB3 + $\Delta$VEB3) of the PNP transistor Q3 by the resistors R3 and R4 and expressed by the following equation (3):

$$VB2 = \frac{R4}{R3+R4} \times \{VDD - (VEB3 + \Delta VEB3)\} \tag{3}$$

The variation of the base potential VB2 of the PNP transistor Q2 with temperature change in this case is shown by a curve VB2 in Fig. 2.

The drain voltage VD of the FET Q1 is a sum of the base potential VB2 of the PNP transistor Q2 and the emitter-base voltage (VEB2 + $\Delta$VEB2) of the PNP transistor Q2 and expressed by the following equation (4):

$$VD = VB2 + (VEB2 + \Delta VEB2) \tag{4}$$

From the equations (3) and (4), the following equation (5) is obtained:

$$VD = \frac{R4}{R3+R4} \cdot VDD + \{VEB2 + \Delta VEB2 - \frac{R4}{R3+R4} \cdot (VEB3 + \Delta VEB3)\} \tag{5}$$

In order to understand the equation (5), the equation (5) is further simplified as the following equation (6) under assumption that the PNP transistors Q2 and Q3 are of substantially the same kinds having substantially the same temperature caused variations of the emitter-base voltages, that is, VEB2 $\fallingdotseq$ VEB3 and $\Delta$VEB2 $\fallingdotseq$ $\Delta$VEB3. In this case, VEB2 + $\Delta$VEB2 and VEB3 + $\Delta$VEB3 are shown in Fig. 2.

$$VD = \frac{R4}{R3+R4} \cdot VDD + \frac{R3}{R3+R4} \cdot (VEB2 + \Delta VEB2) \tag{6}$$

It is clear from the equation (6) that, since the first term of the right side of the equation (6) is sufficiently large compared with the second term thereof, the drain voltage VD has substantially a constant value regardless of temperature change.

This fact is shown by a curve VD in Fig. 2.

Influence of the temperature caused variation of the emitter-base voltage of the PNP transistor Q2 on the drain voltage VD is obtained by differentiating the equation (6) with $\Delta$VEB2 as follow:

$$\frac{\Delta VD}{\Delta VEB2} = \frac{R3}{R3+R4} \tag{7}$$

On the other hand, according to the prior art bias circuit, the base potential VB' of the PNP transistor Q2 is given by a ratio of the resistor R6 to the resistor R7 as follow:

$$VB' = \frac{R7}{R6+R7} \cdot VDD \tag{8}$$

Since the drain voltage VD' of the FET Q1 is a sum of the base potential VB2' and the emitter-base voltage (VEB2 + $\Delta$VEB2), it can be expressed by the following equation (9):

$$VD' = \frac{R7}{R6+R7} \cdot VDD + (VEB2 + \Delta VEB2) \tag{9}$$

By differentiating the equation (9) with $\Delta VEB2$, the following equation is obtained:

$$\frac{\Delta VD'}{\Delta VEB2}=1 \tag{10}$$

Comparing the equation (7) with the equation (10), it is clear that, in the bias circuit according to the present invention, the influence of the temperature caused variation of the emitter-base voltage of the PNP transistor Q2 on the drain voltage of the FET Q1 is restricted to $R3/(R3 + R4)$ compared with that in the prior art bias circuit.

Further, the drain current ID flowing through the FET Q1 is obtained by the equation (1) as follow:

$$ID=\frac{VDD-VD}{R1} \tag{11}$$

From the equations (6) and (11), the following equation is obtained:

$$ID=\frac{1}{R1}\cdot\frac{R3}{R3+R4}\cdot\{VDD-(VEB2+\Delta VEB2)\} \tag{12}$$

The influence of the temperature caused variation of the emitter-base voltage of the PNP transistor Q2 on the drain current is obtained by differentiating the equation (12) with $\Delta VEB2$ as follow:

$$\frac{\Delta ID}{\Delta VEB2}=\frac{-1}{R1}\cdot\frac{R3}{R3+R4} \tag{13}$$

Similarly, the drain current ID' flowing through the prior art bias circuit becomes as follow:

$$ID'=\frac{VDD-VD'}{R1} \tag{14}$$

By combining the equations (9) and (14), the following equation is obtained:

$$ID=\frac{1}{R1}\cdot\{\frac{R6}{R6+R7}\cdot VDD-(VEB2+\Delta VEB2)\} \tag{15}$$

The influence of the temperature caused variation of the emitter-base voltage of the PNP transistor Q2 on the drain current is obtained by differentiating the equation (15) with $\Delta VEB2$ as follow:

$$\frac{\Delta ID'}{\Delta VEB2}=\frac{-1}{R1} \tag{16}$$

Comparing the equation (13) with the equation (16), it is clear that, in the bias circuit for FET according to the present invention, the influence of the temperature caused variation of the emitter-base voltage of the PNP transistor Q2 on the drain current of the FET Q1 is restricted to $R3/(R3 + R4)$ compared with that in the prior art bias circuit.

Although, in order to simplify the description, the PNP transistors Q2 and Q3 have been described as having substantially the same base-emitter voltage characteristics and the same temperature caused variation of the base-emitter voltages, it is practically difficult to obtain transistors having the same characteristics.

However, when two transistors of the same kind are selected, the difference between them is very small and the change of drain current can be restricted sufficiently. When an integrated circuit including two PNP transistors as the PNP transistors Q2 and Q3 is used, it is possible to obtain PNP transistors having substantially the same characteristics.

Now, preferred embodiments of the present invention will be described in detail with reference to the drawings.

Referring to Fig. 1, a GaAs FET is used as the amplifying FET Q1 for amplifying a signal having frequency in a micro wave band. The GaAs FET Q1 has the drain connected to the emitter of a silicon PNP transistor as the PNP transistor Q2 and through a chip resistor as the resistor R1 to the positive power source VDD and the gate connected to the collector of a silicon PNP transistor as the PNP transistor Q2 and through a chip resistor as the resistor R2 to the negative power source VGG. A silicon PNP transistor as the PNP transistor Q3 which is the same kind as that of the silicon PNP transistor Q2 has the emitter connected to the positive power source VDD, the base and the collector connected to the base, through a chip resistor as the resistor R3 to the base of the silicon PNP transistor Q2 and through a chip resistor as the resistor R4 to ground.

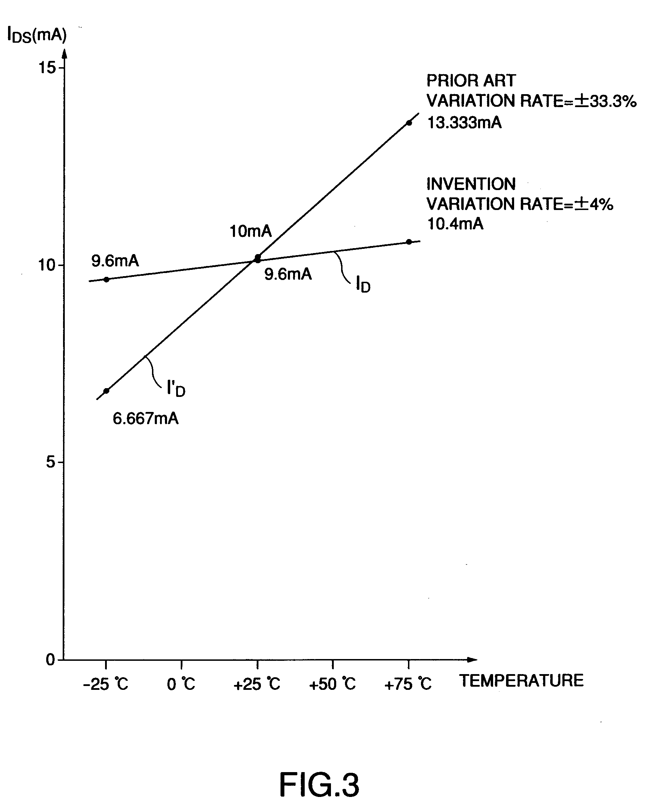

An operation of this embodiment will be described in detail with reference to Fig. 3 with assumption of the positive power source voltage VDD = +3.3V, VEB2 = VEB3 = +0.7V, $\Delta$VEB2 = $\Delta$VEB3 = +0.1V at -25°C, 0V at +25°C, -0.1V at +75°C (temperature characteristics of an emitter-base voltage of a bipolar transistor is usually considered as being - 2mV/°C), the negative power source voltage VGG = -3V, R1 = 30$\Omega$, R2 = 24k$\Omega$, R3 = 3k$\Omega$, R4 = 23k$\Omega$, R6 10k$\Omega$ and R7 = 23k$\Omega$.

The base voltage VB2 of the PNP transistor Q2 is obtained by the equation (3), that is, vB2 = 2.212V at -25°C, 2.3V at +25°C, 2.388V at +75°C.

The drain voltage VD of the FET Q1 is obtained by the equation (4), that is, VD = 3.012V at -25°C, 3.0V at +25°C, 2.988V at +75°C.

The drain current ID of the FET Q1 is obtained by the equation (11), that is, ID = 9.6mA at -25°C, 10mA at +25°C, 10.4mA at +75°C.

These are shown in Fig. 3.

The variation rate of the drain current at room temperature is, in this case, ±4%.

On the other hand, according to the equation (8), the base VB2' of the PNP transistor Q2 of the prior art bias circuit is 2.3V regardless of temperature.

According to the equation (9), the drain voltage VD' of the FET Q1 is 3.1V at -25°C, 3.0V at +25°C and 2.9V at +75°C.

According to the equation (14), the drain current ID' is 6.667mA at -25°C, 10mA at +25°C and 13.333mA at +75°C. These are shown in Fig. 3.

Therefore, the variation rate of the drain current of the prior art bias circuit at room temperature is ±33.3%.

From the foregoing, it is clear that the variation rate of the drain current with temperature variation is substantially improved according to the present invention.

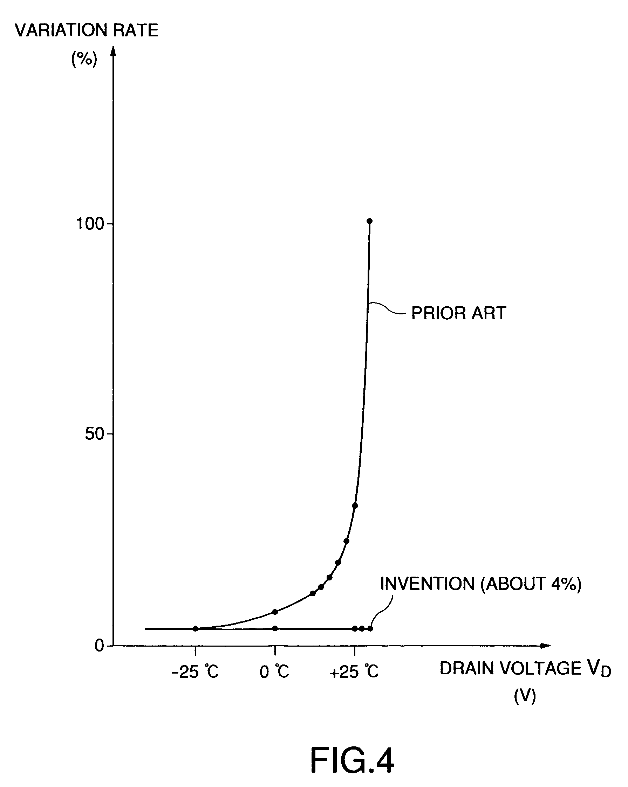

Fig. 4 shows the drain current variation rate characteristics of the present bias circuit and the prior art bias circuit. That is, Fig. 4 shows a result of calculation of the drain current variation rate at room temperature when the drain voltage VD is changed with the positive power source voltage VDD being +3.3V.

According to the bias circuit of the present invention, the variation rate of drain current is constantly about 4% regardless of the setting of the drain voltage VD, while, according to the prior art bias circuit, the variation rate increases with increase of the drain voltage.

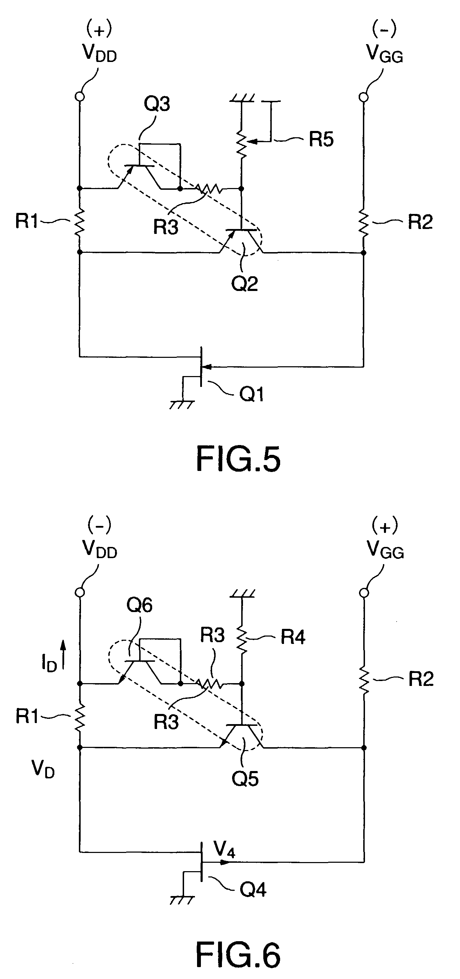

A second embodiment of the present invention will be described with reference to Fig. 5. The second embodiment differs from the first embodiment shown in Fig. 1 in that the fixed resistor R4 of the first embodiment is replaced by a variable resistor R5. As mentioned previously, it is almost impossible practically to have the PNP transistors Q2 and Q3 having completely the same emitter-base voltage characteristics even when these transistors are of the same type. In such case, the drain voltage of the FET Q1 may be deviated from a design value and hence the drain current may be deviated from a design value. However, by using the variable resistor R5 in lieu of the fixed resistor, it is possible to regulate the drain voltage and hence the drain current.

Although, in the preferred embodiments of the present invention, the FET Q1 is the N channel junction type transistors and the positive power source voltage is VDD, the present invention is not limited to them.

Fig. 6 shows a bias circuit using a P channel depletion type FET Q1. In Fig. 6, a negative power source voltage is VDD and a positive power source voltage is VGG. In the bias circuit shown in Fig. 6, transistors Q2 and Q3 are NPN transistors. With the bias circuit shown in Fig. 6, the same characteristics as that obtained by the bias circuit shown in Fig. 1 or 5 can be obtained.

As described hereinbefore, the present invention featured by the addition of the second PNP transistor to the bias portion of the first PNP transistor can compensate for the temperature caused variation of the emitter-base voltage of the first PNP transistor.

As a result, it is possible to restrict the variation of the drain current due to temperature variation even when the drain voltage of the FET Q1 is set in the vicinity of the positive power source voltage.

**Claims**

1. A bias circuit for a field effect transistor amplifier having a field effect transistor having a drain terminal connected to a first power source, a gate terminal connected to a second power source and a source terminal grounded, comprising:

   a first transistor connected between said drain terminal and said gate terminal of said field effect transistor; and
   a second transistor connected between said first power source and a base terminal of said first transistor.

2. A bias circuit as claimed in claim 1, wherein said first and second transistors have substantially the same emitter-base voltage characteristics.

3. A bias circuit as claimed in claim 1, wherein said first and second transistors are provided within a chip.

4. A bias circuit as claimed in claim 1, wherein said first transistor is grounded through a base resistor.

5. A bias circuit as claimed in claim 1, wherein said second transistor has a base and an emitter directly connected to said base.

6. A bias circuit as claimed in claim 1, wherein said field effect transistor is an N channel junction type transistor, said first and second transistors are PNP transistors, said first power source is a positive D.C. power source and said second power source is a negative D.C. power source.

7. A bias circuit as claimed in claim 1, wherein said field effect transistor is a P channel depletion type transistor, said first and second transistors are NPN transistors, said first power source is a negative D.C. power source and said second power source is a positive D.C. power source.

8. A bias circuit as claimed in claim 4, wherein said base resistor is a variable resistor.

9. A bias circuit as claimed in claim 1, wherein said field effect transistor amplifier is a high frequency amplifier in a micro wave band.

10. A bias circuit for a field effect transistor amplifier having a field effect transistor having a drain terminal connected to a positive D.C. power source, a gate terminal connected to a negative D.C. power source and a source terminal grounded, comprising:

   a first PNP transistor connected between said drain terminal and said gate terminal of said field effect transistor;
   a first resistor connected between said drain terminal of said field effect transistor and said positive D.C. power source;
   a second resistor connected between said gate terminal of said field effect transistor and said negative D.C. power source;
   a second PNP transistor connected between said positive D.C. power source and a base terminal of said first PNP transistor and having a base and an emitter connected directly to said base, wherein emitter-base voltage characteristics of said first and second PNP transistors are substantially the same.

11. A bias circuit for a field effect transistor amplifier having a field effect transistor having a drain terminal connected to a negative D.C. power source, a gate terminal connected to a positive D.C. power source and a source terminal grounded, comprising:

   a first NPN transistor connected between said drain terminal and said gate terminal of said field effect transistor;
   a first resistor connected between said drain terminal of said field effect transistor and said negative D.C. power source;
   a second resistor connected between said gate terminal of said field effect transistor and said positive D.C. power source;
   a second PNP transistor connected between said positive D.C. power source and a base terminal of said first PNP transistor and having a base and an emitter connected directly to said base, wherein emitter-base voltage characteristics of said first and second PNP transistors are substantially the same.

FIG.1

FIG.2

FIG.3

VARIATION RATE
(%)

PRIOR ART

INVENTION (ABOUT 4%)

-25 ℃      0 ℃     +25 ℃      DRAIN VOLTAGE V$_D$
(V)

FIG.4

**FIG.5**

**FIG.6**

FIG.7
PRIOR ART